# EUROPEAN PATENT APPLICATION

(11) **EP 1 768 215 A2**
(43) Date of publication of application: **28.03.2007**
(21) Application number: 06121218.9
(22) Date of filing: 25.09.2006
(51) Int. Cl.: H01R 12/08, H01R 12/16, H05K 3/36

(54) **Plasma Display Device**

(30) Priority: 27.09.2005 KR 20050090000
(71) Applicant: Samsung SDI Co., Ltd., Suwon-si, Gyeonggi-do (KR)
(72) Inventor: Kim, Chul-Hong c/o Legal & IP Team Samsung SDI Co., Kyunggi-do (KR); Jung, Jin-Keun c/o Legal & IP Team Samsung SDI Co., Kyunggi-do (KR)
(74) Representative: Walaski, Jan Filip

(57) **Abstract**

The present invention relates to a plasma display panel which includes a plasma display panel, a driving circuit for driving the plasma display panel, an electrical signal transmitting wire for electrically connecting an electrode extended from the plasma display panel to the driving circuit, and an adhesive film interposed between the terminal end of the electrical signal transmitting wire and the terminal end of the electrode of the plasma display panel and electrically connecting between terminal ends. The adhesive film includes an anisotropic conductive film layer having a plurality of conductive particles and an insulated dummy at either or both ends of the anisotropic conductive film layer. Alternatively, the adhesive film may include a plurality of conductive particles with an insulated layer on each side.

## Description

The present invention relates to a plasma display device. More particularly, the present invention relates to a plasma display device in which a connecting member is improved to have a high adhesive insulating property.

A plasma display panel is a device using a plasma discharging structure to display an image.

Such a plasma display device includes an electrode (for example, an address electrode) which is electrically connected to a driving circuit via a flexible printed circuit (FPC). The FPC includes a driver integrated circuit (IC) which applies voltages depending on the signal controlled by the driving circuit to selectively provide the wall voltage to the region corresponding to pixels of the plasma display panel.

For such a device, a chip on film (COF) has generally been used to applying the voltage using the FPC and the driver IC. More recently, a tape carrier package (TCP) has been used and its benefits include smaller size and lower cost.

The FPC or the TCP is electrically connected to the metal electrode terminal using an anisotropic conductive film (ACF). The anisotropic conductive film is generally a resin film made conductive by the inclusion of conductive metal particles.

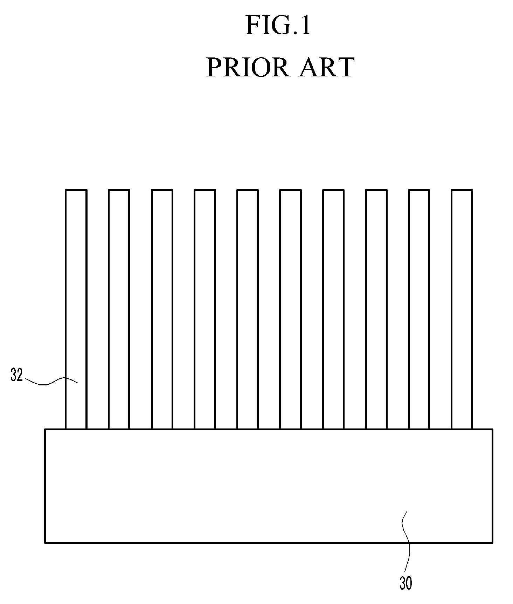

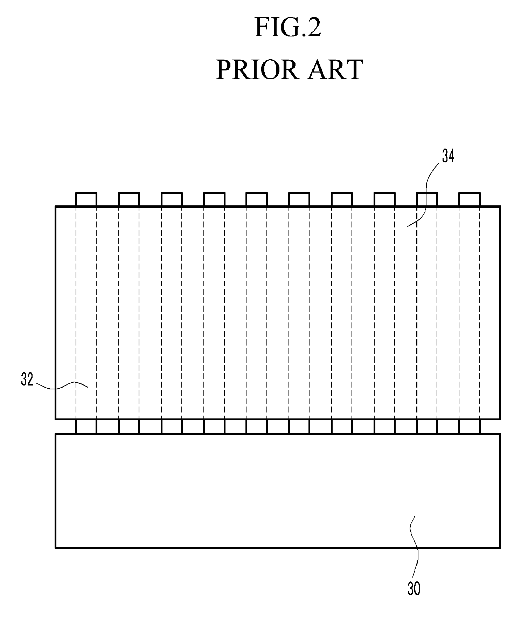

Hereinafter, the connection structure of a prior art anisotropic conductive film is described in more detailed. According to Figures 1 and 2, an electrode terminal 32 of the plasma display panel 30 is attached with the anisotropic conductive film 34. Then, the FPC terminal is introduced thereon, and the electrode of the plasma display panel and the terminal of the FPC are compressed to electrically connect the ball-type conductive metal particles dispersed in the conductive resin of the plasma display panel to the electrode of the plasma display panel and to the terminal of the FPC.

As shown in Figure 2, the anisotropic conductive film is attached by applying the anisotropic conductive film to the electrode terminal with the exception of the portion of the electrode terminal that connects with the plasma display panel and the portion of the electrode terminal to be connected with the FPC. In other words, the initial portion and the end portion of the terminal are not covered with the anisotropic conductive film. This prevents the aggregation of the conductive metal particles from the anisotropic conductive film on those portions of the electrode terminal when the anisotropic conductive film is expanded during the compressing process, preventing an electrical connection between the electrode of the plasma display panel and the terminal of the FPC in order to prevent a potential short circuit.

However, the conductive resin of the anisotropic conductive film still flows out during the compression process and the conductive metal particles tend to aggregate at the initial and end portions of the electrode terminal which can result in a short circuit. Further, an excess of the conductive metal particles tend to aggregate at the gap portion instead of the electrode portion during the compression process. In general, about 30% of the conductive metal particles are present at the electrode with about 70% at the gap away from the electrode. As a result, electron movement is not facilitated between terminals due to the use of the conductive metal particles.

In addition, in a plasma display device having such structure, the address electrode is mainly coated with silver. This can lead to a short circuit since air pockets, voids, and pores are generated due to impurities between the terminals, the low adhesive strength of the anisotropic conductive film, and since the micropores are generated in the anisotropic polymer of the anisotropic conductive film during the compression process. The problems also include migration that occurs due to the adhesive reinforcement of the electrode.

One embodiment of the present invention provides a plasma display panel in which a connecting part is improved to have high adhesive and insulation properties. According to an embodiment of the present invention, the plasma display device includes a plasma display panel, a driving circuit for driving the plasma display panel, an electrical signal transmitting wire electrically connecting an electrode extended from the plasma display panel to the driving circuit, and an adhesive film interposed between the terminal of the electrical signal transmitting wire and the terminal of the electrode of the plasma display panel and connecting both terminals. In such an embodiment, the adhesive film includes an anisotropic conductive film including conductive particles.

According to another embodiment of the present invention, the adhesive film includes an anisotropic conductive film including conductive particles and at least one insulated section referred to as a "dummy" the dummy being located either at the end of the anisotropic conductive film toward the plasma display panel, at the opposite end, or at both ends.

According to yet another embodiment of the present invention, the adhesive film includes an anisotropic conductive comprising a plurality of conductive particles with insulated layers positioned on either side to form the anisotropic conductive film layer.

Embodiments of the present invention are now described, by way of example and with reference to the accompanying drawings, of which:
Figure 1 is a schematic view of a metal electrode of a plasma display panel device according to the prior art;
Figure 2 is a schematic view of a metal electrode including an anisotropic conductive film according to the prior art;
Figure 3 is a schematic view of a metal electrode including an anisotropic conductive film according to an embodiment of the present invention;
Figure 4 illustrates a process of equipping a metal electrode with an anisotropic conductive film according to another embodiment of the present invention;
Figure 5 is a schematic view of a plasma display device according to an embodiment of the present invention; and
Figure 6A to 6D are photographs showing address electrodes of plasma display devices according to Example 1 and Comparative Examples 1 to 3, respectively.

An exemplary embodiment of the present invention will hereinafter be described in detail with reference to the accompanying drawings.

The present invention relates to an adhesive film such as an anisotropic conductive film (ACF) connecting a metal bus electrode and an address electrode to an electrical signal transmitting wire such as FPC or TCP. According to an embodiment of the invention, the electrode is connected to the electrical signal transmitting wire using conductive particles provided in an adhesive film, but the conductive particles do not aggregate, and do not migrate by an excessive amount away from the electrode. This helps to prevent formation of an abnormal conductive path in order to facilitate electron transmission while preventing a short circuit.

According to an embodiment of the present invention, the plasma display device includes a plasma display panel, a driving circuit for driving the plasma display panel, an electrical signal transmitting wire electrically connecting the electrode and extending from the plasma display panel to the driving circuit, and an adhesive film interposed between the terminal of the electrical signal wire and the terminal of the electrode of the plasma display panel, electrically connecting the terminals.

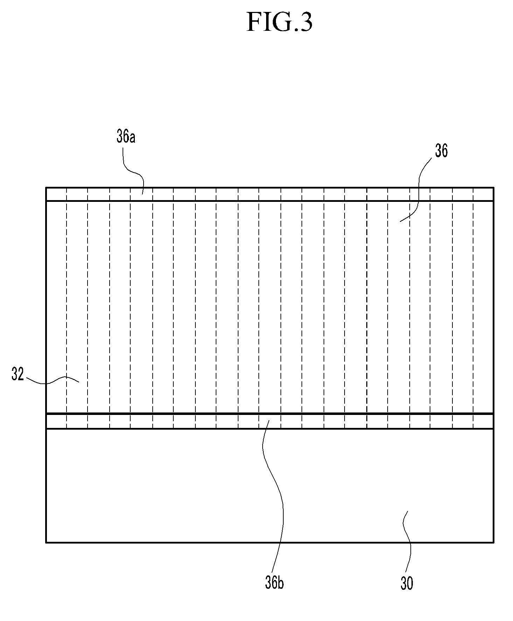

According to an embodiment of the present invention, the adhesive film includes an anisotropic conductive film including conductive particles with an insulated dummy at least one of the terminal ends. The insulated dummy may be provided at an end of the anisotropic conductive film toward the plasma display panel, at the opposite end, or at both ends. As illustrated in Figure 3, a plasma display panel 30 with an electrode terminal 32 is provided as is known in the art. According to this embodiment, the anisotropic conductive film 36 is provided with a first insulated portion, or dummy 36b at the end of the anisotropic conductive film 36 toward the plasma display panel, and a second insulated portion, or dummy 36a at the opposite end of the anisotropic conductive film 36.

The insulated dummies 36b and 36a represent insulated dummy layers that are not electrically conductive. When such insulated dummies are used, the polymer resin for the anisotropic film does not flow out from the adhesive film during the compression process and the conductive particles do not aggregate at the initial terminal and the end terminal of the adhesive film. According to such an embodiment, short circuits are preventable.

The electrically insulated dummy may be a highly adhesive insulated polymer layer, which includes good adhesive properties, and may also be a humidity resisting polymer. Suitable polymers include, but are not limited to, epoxy resins, acryl resins, and acrylate resins.

According to an embodiment of the invention, the adhesive film further includes an anisotropic film layer with conductive particles in its center portion. The conductive particles may include, but are not limited to, metal particles in which a metal such as nickel, copper, or silver is coated with a metal such as gold or palladium, or may include polymer particles substantially spherical in shape are coated with a metal such as gold or palladium. Examples of the polymer resin include, but are not limited to, polystyrene, polyacetylene, polymethylmethacrylate, polymethylethacrylate, and polythiophene.

Suitable materials for the anisotropic conductive film layer include, but are not limited to, epoxy resin, acryl resin, and acrylate resin.

The adhesive film according to another embodiment of the present invention includes an anisotropic conductive film layer comprising a plurality of conductive particles with insulating layers provided on either side.

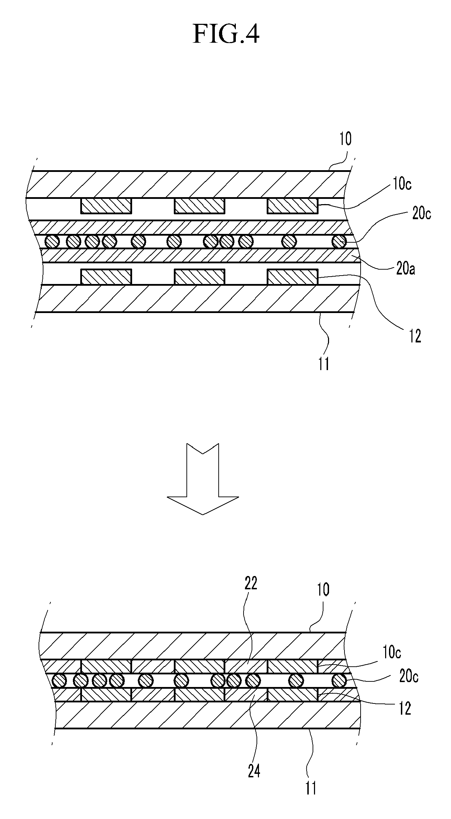

According to Figure 4, the anisotropic conductive film layer comprises a plurality of conductive particles 20c with insulating layers 20a on either side, the anisotropic conductive film layer being dispersed is placed between the driving electrode 12 of the plasma display panel 11 and the terminals 10c of the electrical signal transmitting wire 10. As further shown in Figure 4, the construct is compressed so that the conductive particles 20c are displaced between the driving electrode 12 and the terminal 10c of the electrical signal transmitting wire 10 and the conductive particles 20c are not present in the spaces 22 and 24 between the driving electrodes 12 or the terminals 10c.

An adhesive film having a structure according to such an embodiment can efficiently prevent undesirable aggregation of the conductive particles.

According to still another embodiment of the present invention, the adhesive film includes properties of both the two embodiments described above. The conductive particles are positioned within a pair of insulated layers, and dummy layers are provided on either end. Such an embodiment effectively controls the aggregation of the conductive particles and prevents the generation of air pockets and air bubbles caused by the low adhesive property of the adhesive film.

Hereinafter, a plasma display device including an adhesive film according to an embodiment of the present invention is described with reference to the drawing figures.

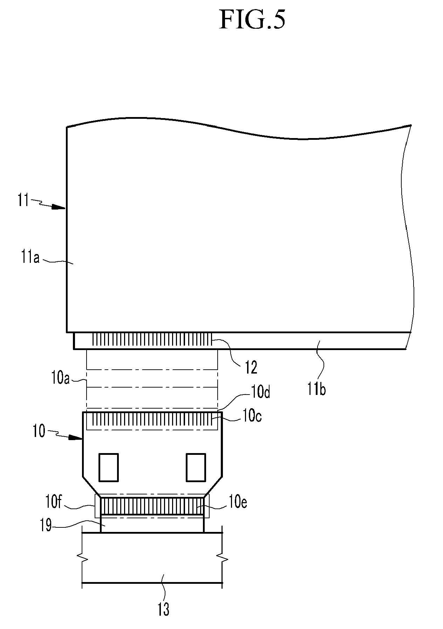

Figure 5 is a schematic view showing the connection between a panel-circuit of the plasma display device according to the present invention.

According to an embodiment of the present invention, a plasma display panel 11 (PDP) includes a driving electrode 12 extending between a front substrate 11a and a back substrate 11b. The driving electrode 12 is electrically connected to the driving circuit 13 via an electrical signal transmitting wire 10 such as a FPC and receives the signal required for driving the device from the driving circuit 13. The driving electrode 12 is electrically connected to a corresponding driving circuit 13 via the corresponding electrical signal transmitting wire 10.

The driving circuit 13 is provided by equipping a circuit member on the Printed Circuit Board (PCB), and is equipped on the opposite surface to that of the PDP 11 on a chassis base.

Although the electrical signal transmitting wire may include the conventional FPC as illustrated in this specification, the present invention is not limited thereto, and may include a driver IC package such as a TCP.

As shown in Figure 5, the driving electrode 12 extends from the PDP 11 as the address electrode and is connected to the driving circuit 13 via the driver IC 10b. The driver IC 10b comprises the driver IC package together with the electrical signal transmitting wire 10.

The driver IC 10b is mounted on the FPC 10a of the electrical signal transmitting wire 10. The FPC 10a includes a first connection 10d in which the terminal ends 10c that are electrically connected with the driving electrode 12 are exposed and a second connection 10f in which the terminal ends 10e that are electrically connected to the driving circuit 13 are exposed.

The first connection 10d is electrically connected to the driving electrode 12 with a film connection 20 interposed between the two. The second connection 10f is electrically connected to the driving wire 13 via a connector 19 in a male/female connecting mode.

As described above, according to the adhesive film of the present invention, the plasma display device can prevent a short circuit between the panel electrode and the wire connection terminal of the FPC by improving the connection between the electrode of the plasma display panel and the FPC.

The following examples illustrate the present invention in detail. However, it is understood that the present invention is not limited by these examples.

### Example 1.

The centre of an adhesive film was equipped with an anisotropic film layer including conductive particles of nickel coated with gold. With the adhesive film, the plasma display device was provided as shown in Figure 2.

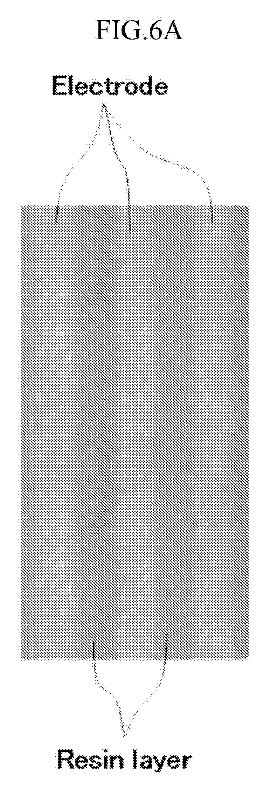

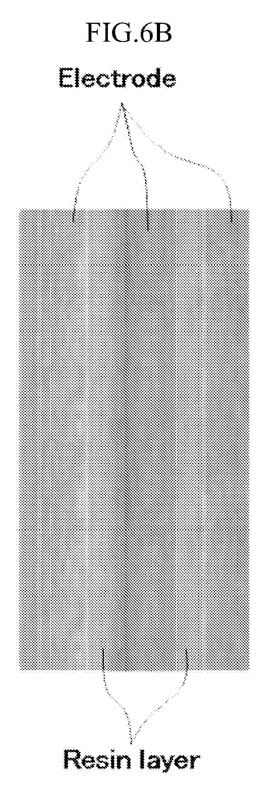

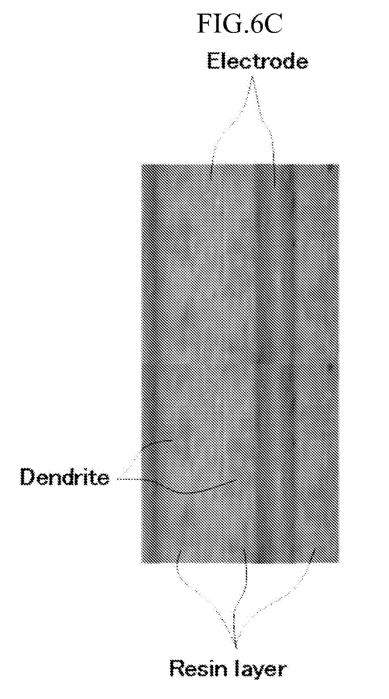

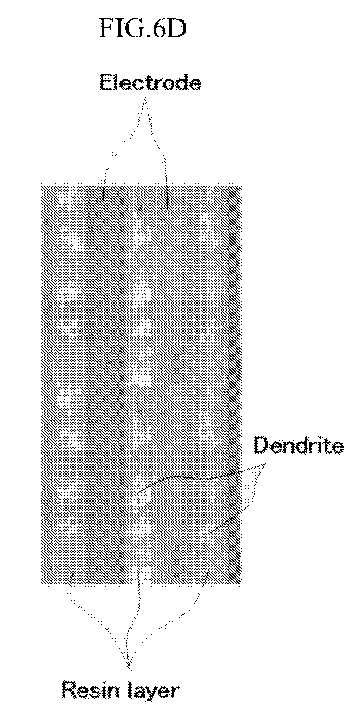

The plasma display device according to Example 1 was applied with DC 70V at a temperature of 60C and a relative humidity of 90% for 96 hours. A photograph of the surface of the address electrode was taken in order to evaluate the migration level, and the results are shown in Figure 6A. Photographs were taken of the surfaces of three different kinds of commercially available plasma display devices for Comparative Examples 1 to 3, and the results are shown in Figures 6B, 6C, and 6D.

Figures 6A to 6D are photographs showing the colour of electrodes in which anisotropic film resin layers were present between electrodes. As shown in Figure 6A, the electrode was not corroded so that the white colour (or lightly shaded portions) was maintained, but a part of electrode surface was corroded to change the colour to brown (or darken the lightly shaded portions) as in Figures 6B to 6D. Particularly, dendrites developed due to the corrosion in Figures 6C and 6D. In other words, the plasma display device according to Example 1 did not generate the migration, but the migration was generated in all of Comparative Examples 1 to 3.

As mentioned above, the plasma display device according to the present invention can prevent short circuits due to the aggregation of conductive particles by providing insulated dummies at the ends of the adhesive film connecting the electrode of the display panel and the electrical signal transmitting wire such as a TCF to improve the adhesive strength between the electrode and the electrical signal transmitting wire. This may be further accomplished by placing the conductive particles between a pair of insulating layers to form the adhesive film.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A plasma display device comprising:
a plasma display panel;
a driving circuit for driving the plasma display panel;
an electrical signal transmitting wire for electrically connecting an electrode extending from the plasma display panel to the driving circuit; and
an adhesive film electrically connecting a terminal end of the electrical signal transmitting wire and a terminal end of the electrode of the plasma display panel, wherein the adhesive film comprises:
an anisotropic conductive film layer comprising a plurality of conductive particles; and
at least one insulated portion disposed at one end of the anisotropic conductive film layer.

2. The plasma display device of claim 1, wherein the at least one insulated portion comprises a highly adhesive insulated polymer material.

3. The plasma display device of claim 2, wherein the highly adhesive insulated polymer material is selected from the group consisting of epoxy resins, acryl resins, and acrylate resins.

4. The plasma display device of any of claims 1 to 3, wherein the conductive particles comprise metal particles or polymer particles.

5. The plasma display device of any one of the preceding claims, wherein the conductive particles comprise particles coated with a metal coating, wherein the particles comprise a material selected from the group consisting of Ni, Cu, Au, Ag, and alloys thereof, and the metal coating comprises a material selected from the group consisting of Au and Pd.

6. The plasma display device of any one of claims 1 to 4, wherein the conductive particles comprise polystyrene polymer particles coated with a metal selected from the group consisting of Au and Pd.

7. The plasma display device of any one of the preceding claims, wherein the anisotropic conductive film layer comprises a material selected from the group consisting of epoxy resins, acryl resins, and acrylate resins.

8. The plasma display device of any one of the preceding claims, wherein the conductive particles are positioned between a pair of insulating layers.

9. The plasma display device of any one of the preceding claims, wherein the insulated portion is disposed at each end of the anisotropic conductive film layer.

10. A plasma display device comprising:
a plasma display panel;
a driving circuit for driving the plasma display panel;
an electrical signal transmitting wire for electrically connecting an electrode extending from the plasma display panel to the driving circuit; and
an adhesive film electrically connecting a terminal end of the electrical signal transmitting wire and a terminal end of the electrode of the plasma display panel,
wherein the adhesive film comprises an anisotropic conductive film layer comprising a sandwich structure having insulated layers spaced apart from one another by a layer of conductive particles.

11. The plasma display device of claim 10, wherein the conductive particles comprise particles selected from metal particles and polymer particles.

12. The plasma display device of claim 11, wherein the conductive particles comprise particles coated with a metal coating, wherein the particles comprise a material selected from the group consisting Ni, Cu, Au, Ag, and alloys thereof, and the metal coating comprises a metal selected from Au and Pd.

13. The plasma display device of claim 11, wherein the conductive particles comprise polystyrene polymer particles coated with a metal selected from the group consisting of Au and Pd.

14. The plasma display device of any one of claims 10 to 13, wherein the anisotropic conductive film layer comprises a material selected from the group consisting of epoxy resins, acryl resins, and acrylate resins.

15. The plasma display device of any one of claims 10 to 14, further comprising at least one insulated dummy at at least one end of the anisotropic conductive film layer.

16. The plasma display device of claim 15, further comprising an insulated dummy at each end of the anisotropic conductive film layer.
